(19) Europäisches Patentamt
European Patent Office
Office européen des brevets

(11) **EP 2 469 585 A2**

(12) **EUROPEAN PATENT APPLICATION**

(43) Date of publication:
**27.06.2012 Bulletin 2012/26**

(51) Int Cl.:
**H01L 21/67** (2006.01)

(21) Application number: **11010019.5**

(22) Date of filing: **20.12.2011**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **21.12.2010 JP 2010284745**

(71) Applicant: **Hitachi High-Tech Instruments Co., Ltd. Kumagaya-shi Saitama 360-0238 (JP)**

(72) Inventors:
• **Imoto, Takuya**
  **Kumagaya-shi**
  **Saitama 360-0238 (JP)**
• **Iida, Shigeru**
  **Kumagaya-shi**
  **Saitama 360-0238 (JP)**
• **Izuhara, Koiti**
  **Kumagaya-shi**
  **Saitama 360-0238 (JP)**

(74) Representative: **Strehl Schübel-Hopf & Partner**
  **Maximilianstraße 54**
  **D-80538 München (DE)**

(54) **Electronic parts mounting apparatus and electronic parts mounting method**

(57) When the remaining number of pats supplied from all parts supply units is greater than or equal to a predetermined threshold value where parts mounting for loading panels as cells on a mother board is performed or parts are mounted on a divided substrate, an electronic parts mounting apparatus performs a parts attraction-mounting operation in an optimization mode in which the time taken for the parts attraction-mounting operation is minimized over the entire substrate. On the other hand, when the remaining number of parts supplied from any parts supply unit reaches less than a predetermined threshold value, the electronic parts mounting apparatus performs a parts attraction-mounting operation in a sequence mode in which a parts attraction-mounting operation at a given substrate portion is continuously performed from the start thereof to its end. Thus, wastes of panels, a divided substrate and parts at their production are eliminated and production efficiency is improved.

FIG. 1

EP 2 469 585 A2

**Description**

## BACKGROUND OF THE INVENTION

The present invention relates to an electronic parts mounting apparatus and an electronic parts mounting method. The invention more particularly relates to an electronic parts mounting apparatus and an electronic parts mounting method suitable for eliminating wastes of panels, divided substrates and parts and improving production efficiency when parts mounting for equipping a mother board with panels as cells is performed or when parts are mounted on each divided substrate.

There has heretofore been known a method in which in an electronic parts mounting apparatus for mounting electronic parts on a substrate, information (mounting data) indicative of to which position any part should be mounted on the substrate is held, information about the substrate is input upon mounting, and the electronic parts are automatically mounted onto the substrate in accordance with the mounting data corresponding to the substrate.

At this time, in what order the parts should be mounted on the substrate becomes an important problem. A technology for optimizing mounting data so as to minimize the time required to mount parts on a sheet of printed circuit board has been disclosed in Japanese Patent Application Laid-Open No. 2003-17900.

Meanwhile, there is known a technique in which a few types of cells are manually fitted onto a mother board and loaded with parts by an electronic parts mounting apparatus to go into production, and thereafter the cells are taken out and produced as products. The mother board at this time serves as a carrier for the cells. A printed circuit board is known which is called a divided substrate that is set so as to separate some of the substrate into each individual unit substrate by perforations and is cut free and used after parts mounting. The divided substrate is particularly often used when a small-sized electronic substrate such as a portable device is produced. A method of providing a divided substrate good in testability has been disclosed in, for example, Japanese Patent Application Laid-Open No. Sho 63(1988)-66988.

As in Japanese Patent Application Laid-Open No. 2003-17900 referred to above, when the parts are mounted on the panels mounted on the mother board or the divided substrate based on the optimized mouthing data, the parts are mounted halfway on a simultaneous parallel basis on a sheet of panel (corresponding to the substrate portion) on the mother board (corresponding to the substrate) or the unit substrate (substrate portion) on the divided substrate. When a parts supply unit is first mounted to the electronic parts mounting apparatus, mountable parts are input. Since the number of the mounted parts is subtracted, the remaining number of mountable parts can be calculated, but unmountable parts appear due to a parts attraction miss and a parts recognition miss upon actual parts mounting. Therefore, although the number of parts is sufficient when calculated, the number of parts runs short and the parts mounting is interrupted in its mid course. At this time, a plurality of in-process panels and unit substrates appear. A problem therefore arises in that the in-process panels and the unit substrates are wasted as well as the parts mounted up to here, and hence production costs will increase.

Such a problem arises in that in an electronic parts mounting apparatus for mounting semiconductor parts or the like, there is provided a rule that an elemental device manufactured from a sheet of wafer is defined as one lot corresponding to a unit (e.g., tape reel unit mounted to a feeder) for product shipment and product management, and the use of parts for a different lot on the same substrate is not desirable for the purpose of maintenance of the performance for each substrate and quality management for a lot unit, thereby discarding all parts without remounting parts of the same type different in lot on a substrate interrupted in parts mounting in the course of the parts mounting.

The present invention has been made to solve the above problems. An object of the present invention is to provide an electronic parts mounting apparatus that automatically mounts parts on a substrate based on mounting data about the parts, in which when parts mounting for equipping a mother board with panels as cells is performed or when parts are mounted on each divided substrate, wastes of panels, divided substrates and parts at the time of production are eliminated and production efficiency is improved.

## SUMMARY OF THE INVENTION

An electronic parts mounting apparatus of the present invention related to a method of mounting electronic parts loaded onto the electronic parts mounting apparatus is an electronic parts mounting apparatus which mounts electronic parts on a substrate having a plurality of substrate portions. The present electronic parts mounting apparatus is of, for example, an electronic parts mounting apparatus which mounts LED panels as one or more cells or mounts electronic parts on a divided substrate with a mother board as a carrier.

The electronic parts mounting apparatus includes a CPU (control unit), a RAM (storage device), parts supply units, and a drive circuit which mounts parts to which mounting positions are designated by the CPU, to their corresponding mounting positions designated on a mother board.

The RAM stores therein mounting data indicative of the parts mounted onto the substrate and the mounting positions of the parts, a parts number management table which manages the number of parts supplied from each of the parts supply units, and an optimum step list in which steps for executing the mounting data are optimized and rearranged. The CPU performs a subtraction on the number of parts used every parts attraction-mounting operation, and writes the remaining number of parts of each parts supply unit into the parts number management table.

When the remaining number of parts supplied from all the parts supply units is greater than or equal to a predetermined threshold value, the CPU determines a parts attraction-mounting operation as being executed in an optimization mode in which the time for the parts attraction-mounting operation is minimized over the entire substrate, and instructs the drive circuit to execute the steps for the mounting data in step order of the optimum step list.

On the other hand, when the remaining number of parts supplied from any parts supply unit reaches less than the predetermined threshold value, the CPU determines a parts attraction-mounting operation as being executed in a sequence mode in which a parts attraction-mounting operation at a given substrate portion is continuously performed from the start thereof to its end, and instructs the drive circuit to execute steps described in mounting data in step order.

The present invention can provide an electronic parts mounting apparatus which automatically mounts parts on a substrate based on mounting data of the parts, in which upon parts mounting for loading a mother board with panels as cells or mounting of parts on a divided substrate, wastes of panels, divided substrates and parts at the time of production are eliminated and production efficiency is improved.

## BRIEF DESCRIPTION OF DRAWINGS

These and other features, objects and advantages of the present invention will become more apparent from the following description when taken in conjunction with the accompanying drawings wherein:

FIG. 1 is a top view of an electronic parts mounting apparatus according to a first embodiment of the present invention;
FIG. 2 is a diagram of a mounting head as viewed from its lower surface;
FIG. 3 is a block diagram of the electronic parts mounting apparatus according to the first embodiment of the present invention;
FIG. 4 is a diagram of a mother board and panels as viewed from a parts mounting surface;
FIG. 5 is a diagram showing the manner of mounting of parts in an optimization mode;
FIG. 6 is a diagram showing the manner of mounting of parts in a sequence mode;
FIG. 7 is a diagram illustrating a mounting operation control table;
FIG. 8 is a diagram depicting a parts remaining number management table;
FIG. 9 is a diagram showing mounting data;
FIG. 10 is a diagram illustrating an optimum step list;
FIG. 11 is a flowchart depicting a pre-parts mounting operation preparing process of the electronic parts mounting apparatus;
FIG. 12 is a flowchart showing a parts mounting operation process of the electronic parts mounting apparatus; and
FIG. 13 is a diagram illustrating a parts mounting operation control panel.

## DESCRIPTION OF THE PREFERRED EMBODIMENT

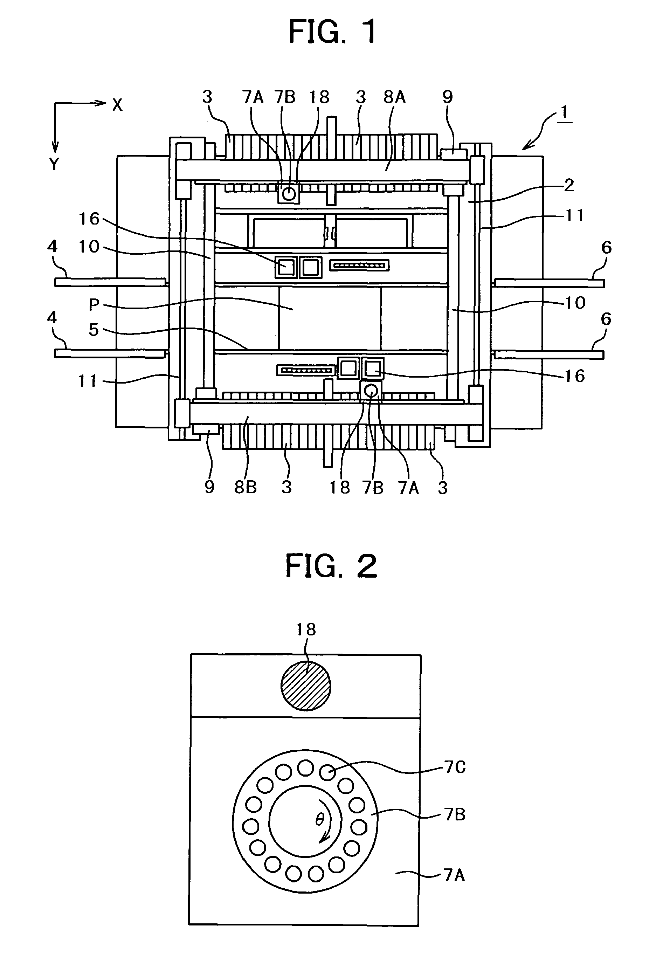

An electronic parts mounting method for an electronic parts mounting apparatus according to a first embodiment of the present invention will hereinafter be explained using FIGS. 1 through 13.

A description will first be made of a configuration of the electronic parts mounting apparatus according to the first embodiment of the present invention using FIGS. 1 through 3.

FIG. 1 is a top view of the electronic parts mounting apparatus according apparatus to the first embodiment of the present invention.
FIG. 2 is a diagram of a mounting head as viewed from its lower surface.

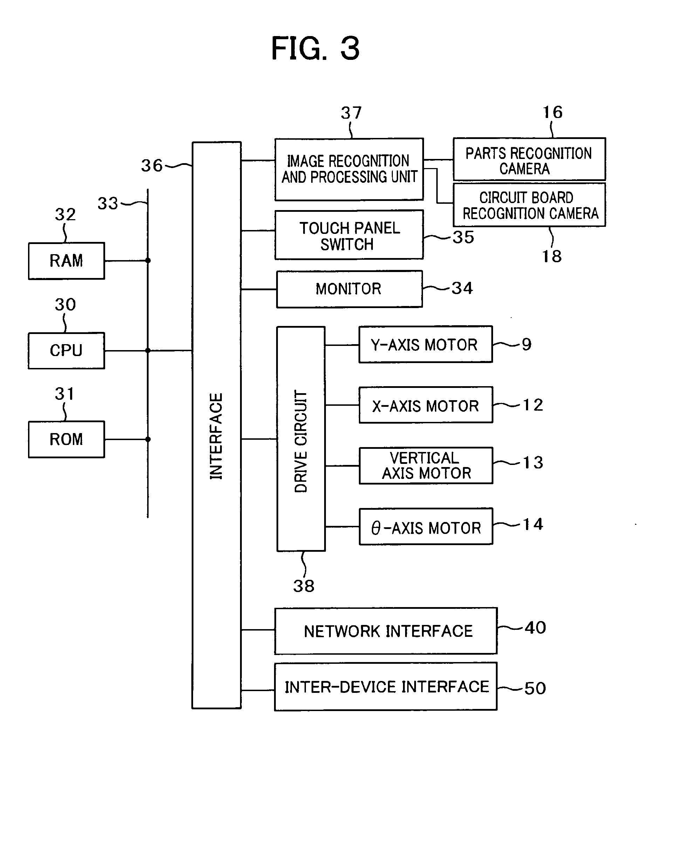

FIG. 3 is a block diagram of the electronic parts mounting apparatus according to the first embodiment of the present invention.

As shown in FIG. 1, the electronic parts mounting apparatus 1 according to the present embodiment is provided side by side with a plurality of parts supply units 3 (hereinafter also called "feeders") on a base 2, which supply various electronic parts to their corresponding parts taking-out portions (parts attraction positions) one by one. A supply conveyer 4, a positioning unit 5 and a discharge conveyer 6 are provided among a group of the parts supply units 3 opposite to one another. The supply conveyer 4 conveys a substrate P that received from a device located on the upstream side to the positioning unit 5, where electronic parts are mounted onto the substrate P positioned and fixed by a positioning mechanism (not shown), followed by conveyance to the discharge conveyer 6.

A pair of beams 8A and 8B are extended long in an X direction and rotates screw shafts 10 by driving of Y-axis motors 9 respectively, whereby the substrate P and the upper parts taking-out positions (parts attraction positions) of the parts supply units 3 are individually moved in a Y direction along a right-and-left pair of guides 11.

Attachment bodies 7A, which move in the longitudinal directions of the beams 8A and 8B, i.e., in the X direction along guides (not shown) by an X-axis motor 12, are provided with mounting heads 7B at the beams 8A and 8B such that the mounting heads 7B are respectively rotatable by a θ -axis motor 14. As shown in FIG. 2, each mounting head 7B has a plurality (about fifteen) of attraction nozzles 7C attached to a body of rotation in a ring form. Each mounting head 7B is equipped with a vertical axis motor 13 for vertically moving the arbitrary attraction nozzles of the attraction nozzles 7C and also equipped with the θ-axis motor 14. Thus, the attraction nozzles 7C of the mounting heads 7B are movable in the X and Y directions (plane direction). The attraction nozzles 7C are rotatable about the perpendicular line and movable vertically.

A parts recognition camera 16 is a camera which images or picks up an electronic part attracted and held by the attraction nozzle 7C from a downward direction.

A substrate recognition camera 18 is a camera which is mounted onto the mounting head 7B and picks up a positioning mark attached to the substrate P and a barcode on a mother board.

Functional blocks of the electronic parts mounting apparatus of the present embodiment are configured as shown in FIG. 3. The respective parts of the electronic parts mounting apparatus are instructed and controlled by a CPU (Central Processing Unit) 30. A ROM (Read Only Memory) 31 that stores a program related to this control therein, and a RAM (Random Access Memory) 32 that stores various data therein are connected to each other via a bus line 33. A monitor 34 for displaying an operation screen or the like, and a touch panel switch 35 used as input means formed in the display screen of the monitor 34 are connected to the CPU 30 via an interface 36.

A network interface 40 connected to an information processing device such as an external server, and an inter-device interface 50 for performing transfer of information to carry out line production in conjunction with another electronic parts mounting apparatus are also connected to the interface 36.

Further, the Y-axis motor 9, X-axis motor 12, vertical axis motor 13, and θ-axis motor 14 are connected to the CPU 30 through the drive circuit 38 and the interface 36.

In the present embodiment, the substrate P is a mother board or divided substrate with each cell built or fitted therein. A description will be made of an example in which parts are mounted on the cell (its details will be explained later). Therefore, mounting data have been stored in the RAM 32 every type of cell fitted in the mother board and related to parts mounting. X and Y directions of mounting coordinates of respective electronic parts in the cells and their angular information, supply parts information, layout number information of the respective parts supply units 3, etc. have been stored therein every parts mounting order (every step number). Information on the type of each electronic part corresponding to the layout number of each parts supply unit 3, and parts layout data have been stored in the RAM 32. Further, parts library data comprised of form data, recognition data, control data and parts supply data has been stored therein.

Incidentally, these data structures related to the present embodiment will also be explained in detail later.

These information stored in the RAM 32 are normally loaded, when necessary, from an auxiliary storage device such as SSD (Solid State Drive), HDD (Hard Disk Drive) or the like although not shown in the drawing.

An image recognition-processing unit 37 is connected to the CPU via the interface 36. The image recognition-processing unit 37 performs recognition processing on an image picked up and captured by the parts recognition camera 16 and sends the result of recognition processing to the CPU 30. That is, the CPU 30 outputs an instruction to the image recognition-processing unit 37 to perform the recognition processing (such as the calculation of an amount of position displacement) on the image picked up by the parts recognition camera 16 and receives the result of recognition processing from the image recognition-processing unit 37.

The image recognition-processing unit 37 performs the recognition processing on an image read by the substrate recognition camera 18 and coverts it into digital information.

A summary of the operation of mounting each part by the electronic parts mounting apparatus according to the present embodiment will next be explained.

A production run for the substrate P is first started. When the substrate P is taken over by a device (not shown) on the upstream side and exists on the supply conveyer 4, the substrate P lying on the supply conveyer 4 is moved to the positioning unit 5, where the substrate P is positioned and fixed.

Next, the substrate recognition camera 18 reads the substrate P and performs recognition processing thereon to thereby determine corresponding mounting data. In accordance with the corresponding mounting data stored in the RAM 32, i.e., mounting data for specifying XY-coordinate positions, rotational angular positions about the axis of the vertical line and FDR numbers (layout numbers of parts supply units 3) or the like to be attached on the substrate P, the Y-axis motors 9 is driven in the Y direction along the pair of guides 11 to move the beam 8A or 8B. Further the X-axis motor 12 is driven in the X direction to move an electronic part to mount any of the attraction nozzles 7C of the corresponding mounting head 7B to above the prescribed parts supply unit 3, and the vertical axis motor 13 is driven to lower the attraction nozzle 7C, thereby adsorbing and taking out the electronic part.

Further, the electronic parts attracted and held while moving the attraction nozzles 7C to above the parts recognition camera 16 are picked up (fly shot) and recognition-processed by the image recognition-processing unit 37. Then, the beam 8A or 8B is moved upward of the substrate P to image or pick up positioning marks attached to the substrate P by the substrate recognition camera 18. Thereafter, the image recognition-processing unit 37 performs recognition processing on the amounts of position displacements thereof. Based on those results, the beam is moved upward of a mounting position of the substrate P again so that the attraction nozzles 7C correct the position displacements by adding both results of recognition to mounting coordinates of mounting data. While such correction is being carried out, all electronic parts attracted and held by the attraction nozzles 7C of the mounting head 7B are mounted onto the substrate P.

Thus, the extraction, recognition and mounting of the electronic parts are repeated until they are completed with respect to all electronic parts to be mounted onto a sheet of substrate P. When they are completed with respect to all, a substrate P is conveyed from the positioning unit 5 to the discharge conveyer 6, so that the production related to electronic parts mounting of the first sheet of substrate P is ended, followed by execution of production relative to a second sheet of substrate P.

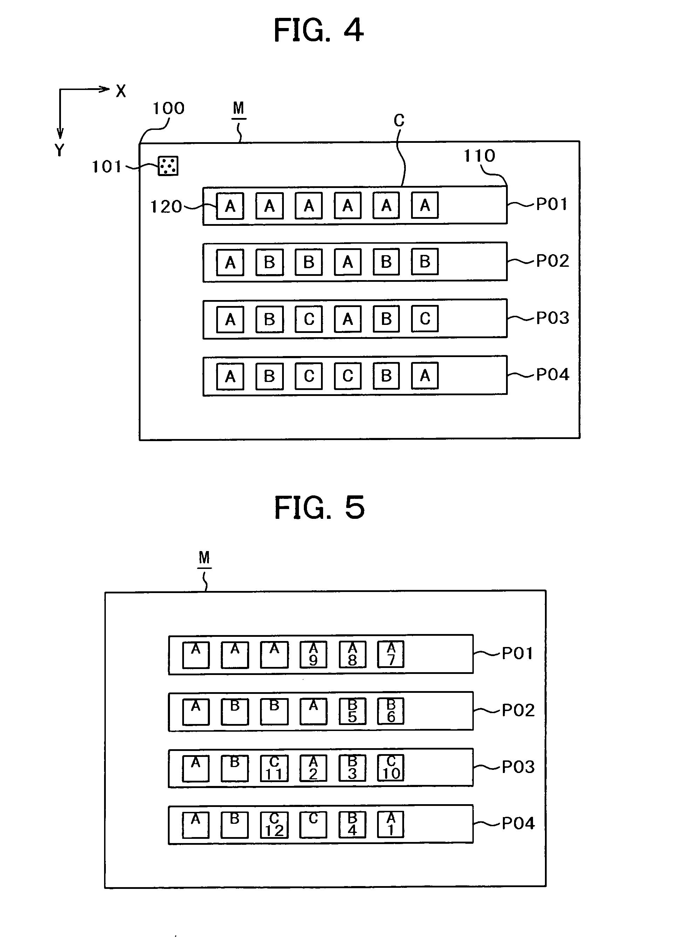

A description will next be made of a mother board and panels that serve as work to mount each electronic part using FIG. 4.

FIG. 4 is a diagram of the mother board and the panels as viewed from a parts mounting surface.

The mother board M is a board in which each cell C is fitted and which serves as a carrier for feeding on a parts mounting line. After the parts mounting has been performed on the cells C, the cells C are detached from the mother board M and reused.

In the present embodiment, each cell C is a rectangular LED panel (hereinafter simply called "panel") equipped with LEDs (Light Emitting Diodes) 120. A description will be made of examples in which various LEDs different in quality from one another are mounted.

As cells C, panels P01, P02, P03 and P04 are manually fitted into the mother board M as a pre-process prior to the feeding thereof into the line of electronic parts mounting apparatus. All the panels are equipped with LEDs as mounted parts. The LEDs that are parts mounted on their corresponding panels are identical in physical form, but different in quality and price or the like. For example, the LEDs are assumed to be ranked in increasing order of quality as A, B, C, ... (hereinafter represented as "LED: A" and so on).

Patterns equipped with parts for panels are various. For example, the panel P01 is equipped with only LED: A, the panel P02 is equipped with LED: A and LED: B in mixed form, the panel P03 is equipped with LED: A, LED: B and LED: C in mixed form. The panel P04 is also equipped with LED: A, LED: B and LED: C in mixed form, but different from the panel P03 in mounting pattern.

In the example of FIG. 4, the number of rows of cells to be equipped with panels is four but may be 10 or so. The number of LEDs of one panel is not shown in the drawing, but is 70 or so. In the example shown in the drawing, LEDs are disposed by one row for each panel, but disposed in the form of plural rows every panel. The transverse width of the mother board M is 500mm or so. Although LEDs are mounted to all parts mounting positions in the drawing, an open region with no LED mounted therein may be provided.

Thus, the panels and LEDs are identical in physical form, but different in terms of the specs of products target for manufacture. Various panel types exist.

A barcode 101 is attached to the mother board M at the upper left thereof. The electronic parts mounting apparatus reads the barcode 101 through the substrate recognition camera 18 shown in FIG. 1. The image recognition-processing unit 37 performs processing for recognizing it as digital data and identifies the mother board. A motherboard origin point 100 is a coordinate origin point at which the electronic parts mounting apparatus performs coordinate processing on the position on the mother board M to mount each part.

A panel origin point 110 is a coordinate origin point at which the electronic parts mounting apparatus performs coordinate processing on the position on each individual panel to mount each part.

Although there is shown, as the mother board M, an example in which the same panel is mounted on one row as a pattern to mount each cell C, each individual cell C (panel in the present example) may not be the same shape. Rectangles different in transverse and longitudinal widths may be combined in arbitrary patterns.

Although the present embodiment has described the example in which the panels are mounted as the cells on the mother board taken as the carrier, the present embodiment may be applied even to a substrate configured as a unit substrate corresponding to each divided substrate set in such a manner that part of the substrate is separated along perforation after mounting of each part.

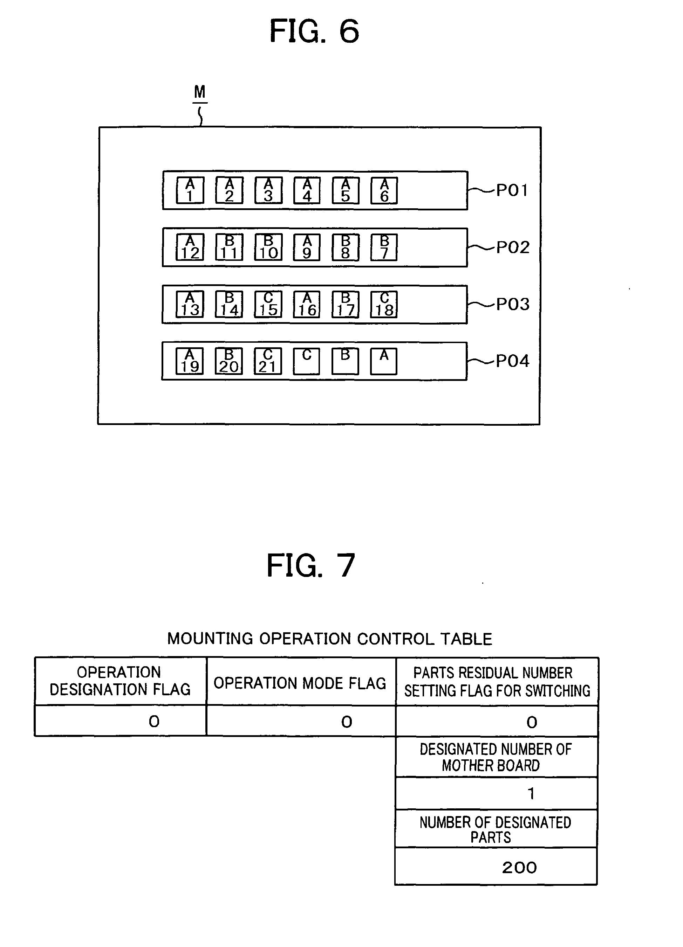

A description will next be made of two modes corresponding to mounting operations used in the electronic parts mounting method according to the first embodiment of the present invention using FIGS. 5 and 6.

FIG. 5 is a diagram showing the manner of mounting of each part in an optimization mode.

FIG. 6 is a diagram showing the manner of mounting of each part in a sequence mode.

The modes for mounting the parts by the electronic parts mounting apparatus according to the present embodiment include the optimization mode and the sequence mode.

The optimization mode is a mode in which the electronic parts mounting apparatus operates so as to mount parts in the order optimized in such a manner that the total time from the attraction of parts to their mounting is minimized. Here, the term "optimized order" indicates the order optimized and determined under a predetermined condition even if the time could be optimized shorter under another condition.

A complicated calculation is required as to in what order parts should actually be mounted in the optimization mode, but generally depends on the following factors.

1) Size of mother board and sequence interval between parts

2) Distance relationship between the placement of each part on mother board and the position of attraction at parts supply unit

3) Number of mounting heads (two in the present embodiment)

4) Number of attraction nozzles mounted to mounting heads and rotational speed.

In the present embodiment, parts are assumed to be mounted as shown in FIG. 5. Incidentally, a description will be made here of a case in which each part is mounted by one head for simplicity. Numerals written in boxes [ ] indicate the order in which parts are to be mounted, and alphabetic characters indicate the type of LED. This drawing shows the completion of mounting of LEDs from 1 to 12.

Incidentally, the parts mounting by the electronic parts mounting apparatus goes through or undergoes (1) movement to an attraction position (plural points if necessary) of a mounting head → (2) movement to a parts mounting position of the mounting head symbol → (3) rotation of the attraction head, if necessary, a phase of rotation of the attraction head → (2) → (3) → (2) → (3) ... → (1). There is therefore a high possibility in the optimization mode that when the mounting of parts is started from a given point, they will be mounted in the vicinity of attraction nozzles until the parts of all the attraction nozzles become empty.

Assuming now that a parts shortage has occurred with respect to LED: C, parts for LED: C supplied to the panel P04 become short. Therefore, a problem arises that five for LED: A, four for LED: B and three for LED: C mounted up to now, and all of the panels P01 through P04 come to naught. This is normally because the rule that parts of different lots are not used for a sheet of substrate is adopted, and the process of mounting parts again on parts-mounting incomplete panels is not provided in consideration of production efficiency.

Thus, the optimization mode has an advantage in that the time required to mount each part becomes short and the production efficiency can be enhanced, but has the potential to waste parts and panels.

The sequence mode is an operation mode in which the mounting of parts on a sheet of panel is continuously performed, and the mounting of parts on other panels is first performed when the mounting of parts on the sheet of panel is completed, without performing the mounting of parts on other panels during the mounting of the parts on the sheet of panel.

In the example shown in FIG. 6, LEDs are mounted in the order of panels P01, P02, P03 and P04. Since the panels P01, P02 and P03 are completed at this time even if a parts shortage has occurred, those panels and the mounted LEDs are not wasted. In the present example, only the panel P04, one for LED: A, one for LED: B and one for LED: C are wasted. Thus, the number of panels that may cause wastage in the sequence mode is one at maximum. The number of LEDs that may cause wastage is the number of parts corresponding to a number mounted on a sheet of panel even at maximum.

The sequence mode is an operation mode in which in contrast to the optimization mode, the time required to mount each part becomes long, and an improvement in production efficiency is not obtained, but the wastage of parts and panels can be suppressed.

A data structure used in the electronic parts mounting method according to the first embodiment of the present invention will next be explained using FIGS. 7 through 10.

FIG. 7 is a diagram showing a mounting operation control table.

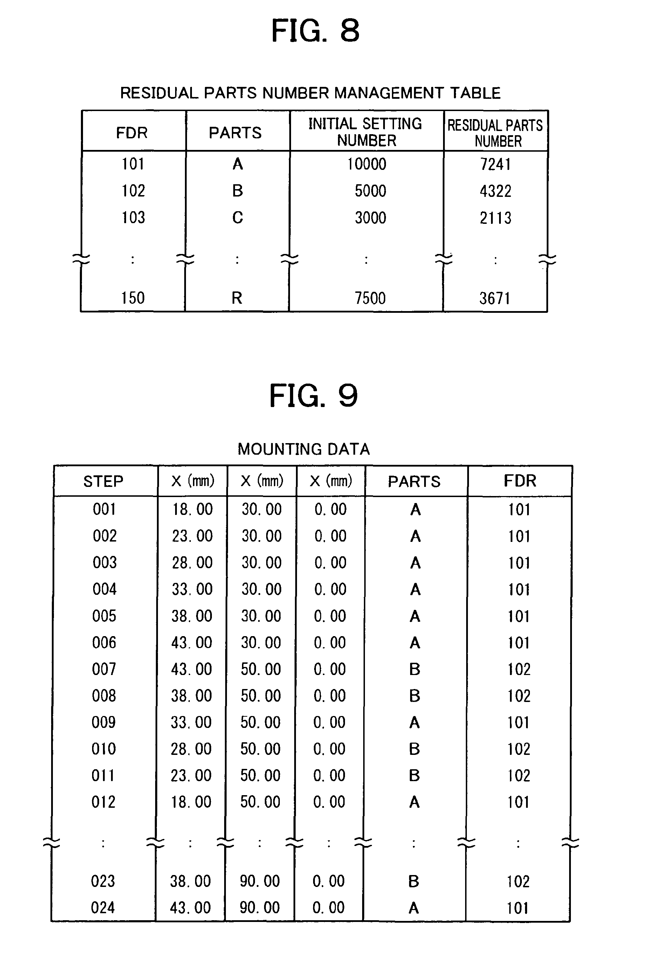

FIG. 8 is a diagram showing a parts remaining number management table.

FIG. 9 is a diagram showing mounting data.

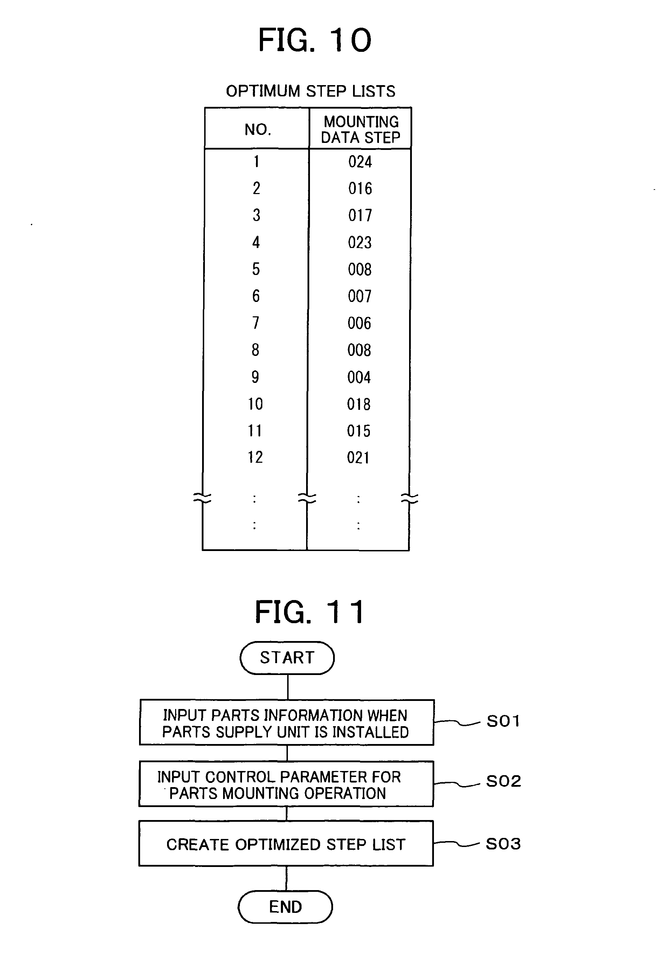

FIG. 10 is a diagram showing an optimum step list.

The mounting operation control table is a table which manages data for controlling a mounting operation of the electronic parts mounting apparatus according to the present embodiment. As shown in FIG. 7, the mounting operation control table is made up of respective fields of an operation designation flag, an operation mode flag, a setting flag for switching, a designated number of mother boards, and a designated number of parts.

The "operation designation flag" is a flag for determination as to whether switching between the optimization mode and the sequence mode in the present embodiment should be performed. When the operation designation flag = 0, for example, the switching between the optimization mode and the sequence mode is assumed not to be performed, and the electronic parts mounting apparatus is always operated in the optimization mode. When the operation designation flag = 1, switching as to whether the electronic parts mounting apparatus should be operated in either the optimization mode or the sequence mode is performed in accordance with the value of the operation mode flag to be described next. For a default, the operation designation flag = 0, and the switching between the optimization mode and the sequence mode is assumed not to be performed. This value can be set by a parts mounting operation control panel as will be described later.

The "operation mode flag" is a parameter which controls whether the electronic parts mounting apparatus is operated in either the optimization mode or the sequence mode. When the operation mode flag = 0, for example, the electronic parts mounting apparatus is operated in the optimization mode. When the operation mode flag = 1, the electronic parts mounting apparatus is operated in the sequence mode. Incidentally, when the operation designation mode = 0 (no switching between the optimization mode and the sequence mode), the operation mode flag = 0 and the electron parts mounting apparatus is operated in the optimization mode.

The "setting flag for switching" is a flag for switching whether the designation at the switching from the optimization mode to the sequence mode is done according to the number of sheets of mother boards or the number of parts. When the setting flag for setting = 0, for example, the designation is done according to the designated number of mother boards. When the setting flag for setting = 1, the designation is done according to the designated number of parts. For a default, the designation of the setting flag for setting = 0 is assumed to be done according to the designated number of mother boards.

The "designated number of mother boards" is a field that becomes effective when the setting flag for setting = 0. When the designated number n of mother boards is set, $(n+1) \times P_i$ is taken as a threshold value when the number of parts $i$ used in the mother boards is $P_i$ (where $i = 1, 2, ...$). When the remaining number $Q_i$ of parts $i$ becomes smaller than that, i.e., when the following (Equation 1) is established with respect to any $i$, the operation mode flag is switched from 0 (optimization mode) to 1 (sequence mode). A default for the designated number n of mother boards is assumed to be 1.

$$(n+1) \times P_i > Q_i \qquad ... \text{(Equation 1)}$$

Assume that the designated number of mother boards = 1 in the case of the mother board shown in FIG. 4, for example. In the mother board shown in FIG. 4, twelve LEDs: A, eight LEDs: B and four LEDs: C are used. Therefore, when any state of the number of LEDs: A being less than 12, the number of LEDs: B being less than eight, and the number of LEDs: C being less than four occurs, the operation mode flag is switched from 0 (optimization mode) to 1 (sequence mode). When the designated number of mother boards = 1 is designated, it means that mother boards up to the final second sheet of mother board that may be parts run-shortage are allowed to operate in the optimization mode, and the last sheet of mother board is allowed to operate in the sequence mode.

The "designated number of parts" is a field that becomes effective when the setting flag for switching = 1. When this becomes smaller than this value at any part, that is, when the designated number of parts is assumed to be R, and the remaining number of parts $i$ is assumed to be $Q_i$, the operation mode flag is changed over from 0 (optimization mode) to 1 (sequence mode) when the following (Equation 2) is established with respect to any $i$. A default for the designated number of parts is set as appropriate according to the specs of mother boards.

$$R > Q_i \qquad ... \text{(Equation 2)}$$

The designated number of mother boards and the designated number of parts can be set by a parts mounting operation control panel as will be described later.

The parts remaining number management table is a table that manages the remaining number of parts every feeder, and consists of respective fields of FDR, parts, an initial setting number, and a parts remaining number.

The "FDR" is an identifier for identifying a feeder which supplies the parts. Although not shown in the drawing, the feeder takes a structure in which a parts storage tape is attached and parts are fed therefrom. The "parts" correspond to the identifiers or names of supplied parts. The "initial setting number" indicates the number of parts stored or accommodated in the storage tape at the time that the parts supply unit is first attached thereto. This can be obtained by causing an operator to input it from the corresponding parts initial setting panel when the operator mounts a feeder during a mounting preparation stage, or reading a barcode of a storage tape attached to the feeder and digitally processing it. At this time, the number of parts may be contained in barcode information itself of the read storage tape, or the number of parts may be obtained based on a database associated with an identifier read from a barcode.

The "remaining number" is the remaining number of parts from the parts supply unit. The number obtained by subtracting the number of parts attracted for mounting from the initial setting number results in the remaining number of parts.

The mounting data are data indicating, in mounting order, at which position any part should be mounted to each panel on the mother board. As shown in FIG. 9, each mounting data includes respective fields of a step, X, Y, θ, parts, and FDR.

Incidentally, although the present embodiment has described the mounting data, based on the coordinate system from the mother board origin 100, the data indicative of the relation between the mother board origin 100 and each panel origin 110 is held and the mounting data may be described based on each relative position from the panel origin 110.

In the sequence mode, the electronic parts mounting apparatus mounts parts in designated positions in step order defined in the mounting data. For example, the first step indicates that LED: A is mounted in a two-dimensional position of X = 18.00 mm and Y = 30.00 mm as viewed from the mother board origin 100 at a rotational angle θ = 0.00 deg from a feeder of a feeder number 101.

The optimum step list indicates the order of operation of the electronic parts mounting apparatus in the optimization mode and has a structure in which the mounting data shown in FIG. 9 are sorted.

For example, in the optimization mode, the respective steps are executed in decreasing order of numbers in FIG. 10 as in the case where the 024 step of the mounting data is first carried out, the 016 step of the mounting data is next carried out, ....

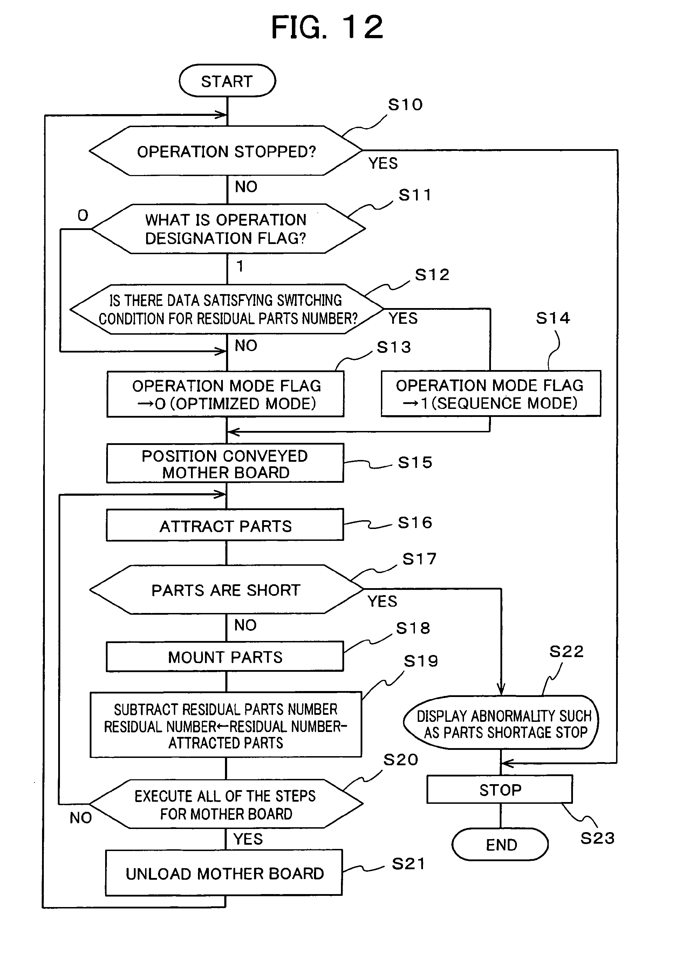

Processing of the electronic parts mounting method according to the first embodiment of the present invention will next be explained using FIGS. 11 and 12.

FIG. 11 is a flowchart showing a pre-parts mounting operation preparing process of the electronic parts mounting apparatus.

FIG. 12 is a flowchart showing a parts mounting operation process of the electronic parts mounting apparatus.

First, as the pre-parts mounting operation preparing process, parts information about the parts names, the number of parts, etc. are first input when a parts supply unit (feeder) is installed (S01 of FIG. 11) . As already described above, this operation may be performed manually by the operator from the parts initial setting panel or by reading the barcode of the storage tape attached to the parts supply unit.

The input parts information is retained in the parts remaining number management table shown in FIG. 8.

Next, a control parameter for a parts mounting operation is input from the parts mounting operation control panel (S02).

The input control parameter for a parts mounting operation control panel is held in the mounting operation control table shown in FIG. 7.

Incidentally, a concrete image of the parts mounting operation control panel will be explained later.

Next, the electronic parts mounting apparatus executes a parts mounting optimization program to thereby perform the optimization calculation, thus creating the optimization step list shown in FIG. 10 (S03).

When the pre-parts mounting operation preparing process is ended, the parts mounting operation process of carrying in a mother board and mounting parts on the corresponding panel can be performed.

A stop decision is made as the parts mounting operation process (S10 of FIG. 12). When a device abnormality has occurred or the mother boards to mount the parts run short, the electronic parts mounting apparatus is stopped (S23).

When the decision of "No" is found from the stop decision, the operation designation flag shown in FIG. 7 is examined. When the operation designation flag = 0 (absence of switching), the parts mounting operation process proceeds to S13. When the operation designation flag = 1 (presence of switching), the parts mounting operation process goes to S12. This is because when no designation is done, the electronic parts mounting apparatus is operated in the optimization mode.

It is next determined whether there is a feeder in which the remaining number of parts satisfies a switching condition (S12). When the setting flag for switching = 0 (designation of mother board) here, the above decision is made according to the condition of (Equation 1) as n = designated number of mother boards. When the setting flag for switching = 1 (parts designation), the above decision is made according to the condition of (Equation 2) as R = designated number of parts.

When it is determined that the feeder that satisfies the switching condition exists, the operation mode flag = 1 (sequence mode). When it is determined that there is no feeder that satisfies the switching condition, the operation mode flag = 0 (optimization mode).

Next, the mother board is carried in and positioned (S15).

A parts attraction operation (S16) is performed in accordance with a mode designated by the operation mode flag.

When it is not possible to perform the parts attraction operation in any feeder, parts shortage is assumed to have occurred (S17). An abnormality of a parts shortage stop is displayed on the corresponding panel (S22) and the electronic parts mounting apparatus is stopped (S23).

When the parts attraction operation is normally performed, the parts mounting operation is performed in accordance with a mode designated by the operation mode flag (S18).

When the parts mounting operation is completed, an arithmetic operation on the remaining number of parts is performed (S19). The part remaining number is set to the "remaining number of parts" of the parts remaining number management table of FIG. 8. The remaining number of parts is determined by the following (Equation 3):

```
Remaining number <- remaining number - attracted number of

parts                             ... (Equation 3)
```

It is next determined whether all steps related to the mother board being mounted at present have been executed (S20). If at least one step is not executed, the parts mounting operation process returns to S16. When the steps to be executed are performed, the mother board is discharged (S21) and the parts mounting operation process returns to S10.

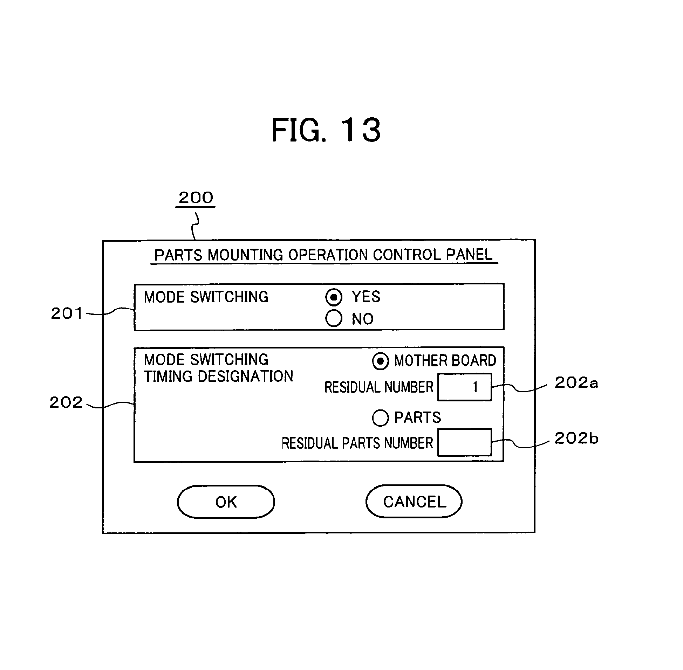

The image of the parts mounting operation control panel will next be explained using FIG. 13.

FIG. 13 is a diagram showing the parts mounting operation control panel.

The parts mounting operation control panel 200 is a panel for inputting parameters for controlling the mounting operation of the electronic parts mounting apparatus according to the present embodiment. The control panel 200 is displayed on the monitor 34 shown in FIG. 1 and can receive inputs using the input device such as the touch panel switch 35.

The parts mounting operation control panel 200 has, as input columns, a mode switching setting column 201 and a switching timing setting column 202.

The mode switching setting column 201 is an input column for setting the operation designation flag shown in FIG. 7. When the operator selects "Yes" , the operation designation flag is set as the operation designation flag = 1. When the operator selects "No", the operation designation flag is set as the operation designation flag = 0.

The switching timing setting column 202 is a region for inputting the "setting flag for switching", the designated number of mother boards" and the "designated number of parts" shown in FIG. 7.

When the operator selects "mother board", the switching setting flag is set as the setting flag for switching = 0. When the operator selects "parts", the switching setting flag is set as the setting flag for switching = 1.

When the term "mother board" is selected, it is possible to make an input to a remaining sheet number input region 202a. The input value is set to the "designated number of mother boards" of the mounting operation control table. When the term "parts" is selected, it is possible to make an input to the remaining parts number input region 202b. The input value is set to the "designated number of parts" of the mounting operation control table.

**Claims**

1. An electronic parts mounting apparatus which mounts electronic parts onto a substrate having a plurality of substrate portions, comprising:

   a control unit;
   a storage device;
   one or more parts supply units; and
   a drive circuit which is used to mount each of parts to each of which a mounting position is designated from the control unit, to a designated mounting position on the substrate,
   wherein the storage device stores therein mounting data indicative of the parts mounted onto the substrate and the mounting positions of the parts, information for managing the number of parts supplied from each of the parts supply units, and optimum step information in which steps for executing the mounting data are rearranged,
   wherein said number of parts managing information holds the number of parts supplied from the parts supply unit,
   wherein the control unit determines the remaining number of parts supplied from the parts supply unit in accordance with a parts attraction-mounting operation, and
   the control unit determines, based on the remaining number of parts supplied from the parts supply unit whether when a parts attraction-mounting operation at a given substrate portion is started, the parts attraction-mounting operation is performed in a sequence mode in which parts attraction-mounting operations at other substrate portions are not started until the mounting of parts by the parts attraction-mounting operation at the given substrate portion is completed, or determines whether the parts attraction-mounting operation is performed in an optimization mode in which a time for the parts attraction-mounting operation is minimized over the entire substrate,

wherein when it is determined that the parts attraction-mounting operation is performed in the sequence mode, the control unit instructs the drive circuit to perform the parts attraction-mounting operations for the substrate based on the mounting data, and

wherein when it is determined that the parts attraction-mounting operation is performed in the optimization mode, the control unit instructs the drive circuit to perform the parts attraction-mounting operations for the substrate in such a manner that the steps for the mounting data are carried out in step order indicated by the optimum step information.

**2.** An electronic parts mounting apparatus according to claim 1,
wherein switching from the operation of the optimization mode to the operation of the sequence mode is performed when the remaining number of parts from any parts supply unit reaches less than a predetermined threshold value.

**3.** An electronic parts mounting apparatus according to claim 2,
for the switching from the operation of the optimization mode to the operation of the sequence mode, the electronic parts mounting apparatus has means for designating a threshold value based on the remaining number of parts from the parts supply unit in substrate sheet-number terms.

**4.** An electronic parts mounting method for an electronic parts mounting apparatus which mounts electronic parts onto a substrate having a plurality of substrate portions, said electronic parts mounting apparatus comprising:

a control unit;
a storage device;
one or more parts supply units; and
a drive circuit which is used to mount each of parts to each of which a mounting position is designated from the control unit, to a designated mounting position on the substrate, said electronic parts mounting method comprising the steps of:

storing in the storage device, mounting data indicative of the parts mounted onto the substrate and the mounting positions of the parts, information for managing the number of parts supplied from each of the parts supply units, and optimum step information in which steps for executing the mounting data are rearranged;

inputting the number of parts supplied from the parts supply unit and storing the same in the information for managing the number of the parts;

causing the control unit to determine a remaining number of parts supplied from the parts supply unit in accordance with a parts attraction-mounting operation and store the determined remaining number of parts in the information for managing the number of the parts;

causing the control unit to determine, based on the remaining number of parts supplied from the parts supply unit whether when a parts attraction-mounting operation at a given substrate portion is started, the parts attraction-mounting operation is performed in a sequence mode in which parts attraction-mounting operations at other substrate portions are not started until the mounting of parts by the parts attraction-mounting operation at the given substrate portion is completed, or causing the control unit to determine whether a parts attraction-mounting operation is performed in an optimization mode in which a time for the parts attraction-mounting operation is minimized over the entire substrate,

causing the control unit to instruct the drive unit to perform the parts attraction-mounting operations for the substrate based on the mounting data when it is determined that the parts attraction-mounting operation is performed in the sequence mode, and causing the control unit to instruct the drive circuit to perform the parts attraction-mounting operations for the substrate when it is determined that the parts attraction-mounting operation is performed in the optimization mode, in such a manner that the steps for the mounting data are carried out in step order indicated by the optimum step information.

**5.** An electronic parts mounting method according to claim 4,
wherein in the step of determining the parts attraction-mounting operation, the determination is made in such a manner that the parts attraction-mounting operation is performed in the sequence mode when the remaining number of parts from any parts supply unit reaches less than a predetermined threshold value, whereas when the remaining number of parts from any parts supply unit does not reach less than a predetermined threshold value, the determination is made in such a manner that the parts attraction-mounting operation is performed in the optimization mode.

# FIG. 1

# FIG. 2

# FIG. 3

```
                    37                           16
  36                ┌──────────────────┐  ┌──────────────────┐
                    │ IMAGE RECOGNITION│  │ PARTS RECOGNITION│
                    │ AND PROCESSING   │  │ CAMERA           │
                    │ UNIT             │  ├──────────────────┤
  33                └──────────────────┘  │ CIRCUIT BOARD    │
 32                 ┌──────────────────┐  │ RECOGNITION CAMERA│
 ┌─────┐            │ TOUCH PANEL      │  └──────────────────┘
 │ RAM │            │ SWITCH           │ ~35          18
 └─────┘            └──────────────────┘

 30                 ┌──────────────────┐
 ┌─────┐            │ MONITOR          │ ~34
 │ CPU │            └──────────────────┘
 └─────┘
                    ┌──────────────────┐
 31                 │ Y-AXIS MOTOR     │ ~9
 ┌─────┐            └──────────────────┘
 │ ROM │
 └─────┘            ┌──────────────────┐
                    │ X-AXIS MOTOR     │ ~12
                    └──────────────────┘

                    ┌──────────────────┐
                    │ VERTICAL         │ ~13
                    │ AXIS MOTOR       │
                    └──────────────────┘

                    ┌──────────────────┐
                    │ θ-AXIS MOTOR     │ ~14
                    └──────────────────┘
                              38

                    ┌──────────────────┐
                    │ NETWORK INTERFACE│ ~40
                    └──────────────────┘

                    ┌──────────────────┐
                    │ INTER-DEVICE     │ ~50
                    │ INTERFACE        │
                    └──────────────────┘
```

INTERFACE

DRIVE CIRCUIT

# FIG. 4

# FIG. 5

# FIG. 6

M

A1  A2  A3  A4  A5  A6  ~P01

A12  B11  B10  A9  B8  B7  ~P02

A13  B14  C15  A16  B17  C18  ~P03

A19  B20  C21  C  B  A  ~P04

# FIG. 7

MOUNTING OPERATION CONTROL TABLE

| OPERATION DESIGNATION FLAG | OPERATION MODE FLAG | PARTS RESIDUAL NUMBER SETTING FLAG FOR SWITCHING |
|---|---|---|
| 0 | 0 | 0 |
| | | DESIGNATED NUMBER OF MOTHER BOARD |
| | | 1 |
| | | NUMBER OF DESIGNATED PARTS |
| | | 200 |

# FIG. 8

RESIDUAL PARTS NUMBER MANAGEMENT TABLE

| FDR | PARTS | INITIAL SETTING NUMBER | RESIDUAL PARTS NUMBER |
|---|---|---|---|
| 101 | A | 10000 | 7241 |
| 102 | B | 5000 | 4322 |
| 103 | C | 3000 | 2113 |
| : | : | : | : |
| 150 | R | 7500 | 3671 |

# FIG. 9

MOUNTING DATA

| STEP | X (mm) | X (mm) | X (mm) | PARTS | FDR |
|---|---|---|---|---|---|
| 001 | 18. 00 | 30. 00 | 0. 00 | A | 101 |
| 002 | 23. 00 | 30. 00 | 0. 00 | A | 101 |
| 003 | 28. 00 | 30. 00 | 0. 00 | A | 101 |
| 004 | 33. 00 | 30. 00 | 0. 00 | A | 101 |
| 005 | 38. 00 | 30. 00 | 0. 00 | A | 101 |
| 006 | 43. 00 | 30. 00 | 0. 00 | A | 101 |
| 007 | 43. 00 | 50. 00 | 0. 00 | B | 102 |
| 008 | 38. 00 | 50. 00 | 0. 00 | B | 102 |
| 009 | 33. 00 | 50. 00 | 0. 00 | A | 101 |
| 010 | 28. 00 | 50. 00 | 0. 00 | B | 102 |
| 011 | 23. 00 | 50. 00 | 0. 00 | B | 102 |
| 012 | 18. 00 | 50. 00 | 0. 00 | A | 101 |
| : | : | : | : | : | : |
| 023 | 38. 00 | 90. 00 | 0. 00 | B | 102 |
| 024 | 43. 00 | 90. 00 | 0. 00 | A | 101 |

# FIG. 10

OPTIMUM STEP LISTS

| NO. | MOUNTING DATA STEP |
|-----|--------------------|
| 1 | 024 |
| 2 | 016 |
| 3 | 017 |
| 4 | 023 |
| 5 | 008 |
| 6 | 007 |
| 7 | 006 |
| 8 | 008 |
| 9 | 004 |
| 10 | 018 |
| 11 | 015 |
| 12 | 021 |
| : | : |
| : | : |

# FIG. 11

```
        START
          |
INPUT PARTS INFORMATION WHEN        S01
PARTS SUPPLY UNIT IS INSTALLED
          |
INPUT CONTROL PARAMETER FOR         S02
 PARTS MOUNTING OPERATION
          |
CREATE OPTIMIZED STEP LIST          S03
          |
         END
```

# FIG. 12

```
                    START

                         │
                         ▼
              ┌──────────────────────┐  S10
         ╱────┤  OPERATION STOPPED?   ├────╲
              └──────────────────────┘      YES
                    │ NO
                         ▼
         ┌──────────────────────────┐  S11
      0 ╱│    WHAT IS OPERATION      │╲
     ────┤   DESIGNATION FLAG?       ├
         └──────────────────────────┘
                    │ 1
                         ▼
     ┌──────────────────────────────────────┐  S12
     │  IS THERE DATA SATISFYING SWITCHING   │╲
     │ CONDITION FOR RESIDUAL PARTS NUMBER?  │  YES        S14
     └──────────────────────────────────────┘
                    │ NO              S13
                         ▼
     ┌──────────────────────┐        ┌──────────────────────┐
     │ OPERATION MODE FLAG   │        │ OPERATION MODE FLAG   │
     │ →0 (OPTIMIZED MODE)   │        │ →1 (SEQUENCE MODE)    │
     └──────────────────────┘        └──────────────────────┘

     ┌──────────────────────┐  S15
     │   POSITION CONVEYED   │
     │    MOTHER BOARD       │
     └──────────────────────┘

     ┌──────────────────────┐  S16
     │     ATTRACT PARTS     │
     └──────────────────────┘

     ┌──────────────────────┐  S17
    ╱│   PARTS ARE SHORT     │╲
     └──────────────────────┘  YES
                    │ NO          S18
     ┌──────────────────────┐
     │     MOUNT PARTS       │
     └──────────────────────┘        S19

     ┌──────────────────────────────┐
     │ SUBTRACT RESIDUAL PARTS NUMBER │        S22
     │ RESIDUAL NUMBER←RESIDUAL       │   ┌──────────────────────┐
     │ NUMBER-ATTRACTED PARTS         │   │ DISPLAY ABNORMALITY   │
     └──────────────────────────────┘   │ SUCH AS PARTS         │
                                         │ SHORTAGE STOP         │
     ┌──────────────────────┐  S20       └──────────────────────┘
    ╱│ EXECUTE ALL OF THE    │╲
     │  STEPS FOR MOTHER     │           ┌──────────────────────┐
  NO │  BOARD                │           │        STOP           │
     └──────────────────────┘           └──────────────────────┘
                    │ YES                          S23
     ┌──────────────────────┐  S21              │
     │ UNLOAD MOTHER BOARD   │              ┌─────────┐
     └──────────────────────┘              │   END   │
                                           └─────────┘
```

# FIG. 13

200

| PARTS MOUNTING OPERATION CONTROL PANEL |
|---|

201 — MODE SWITCHING  ⦿ YES  ○ NO

202 — MODE SWITCHING TIMING DESIGNATION  ⦿ MOTHER BOARD  RESIDUAL NUMBER [ 1 ] — 202a

○ PARTS  RESIDUAL PARTS NUMBER [  ] — 202b

( OK )  ( CANCEL )

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003017900 A
- JP SHO63198866988 B